# EUROPÄISCHE PATENTSCHRIFT

(11) **EP 3 455 681 B1**
(45) Veröffentlichungstag und Bekanntmachung des Hinweises auf die Patenterteilung: **07.08.2019**
(21) Anmeldenummer: 17729097.0
(22) Anmeldetag: 07.06.2017
(51) Int. Cl.: G05B 19/042, G05B 9/02

(54) **FELDBUSMODUL UND VERFAHREN ZUM BETREIBEN EINES FELDBUSSYSTEMS**
FIELDBUS MODULE AND METHOD FOR OPERATING A FIELDBUS SYSTEM
MODULE DE BUS DE TERRAIN ET PROCÉDÉ DE FONCTIONNEMENT D'UN SYSTÈME DE BUS DE TERRAIN

(30) Priorität: 09.06.2016 DE 102016110641
(43) Veröffentlichungstag der Anmeldung: 20.03.2019
(73) Patentinhaber: Beckhoff Automation GmbH, 33415 Verl (DE)
(72) Erfinder: SACHS, Jens, 32469 Petershagen (DE); RETTIG, Thomas, 33378 Rheda-Wiedenbrück (DE); POHL, Christopher, 33415 Verl (DE)
(74) Vertreter: Patentanwaltskanzlei WILHELM & BECK
(86) Internationale Anmeldenummer: PCT/EP2017/063854
(87) Internationale Veröffentlichungsnummer: WO 2017/211895

(56) Entgegenhaltungen:
- EP-A1- 2 778 811
- EP-A2- 1 312 991
- DE-A1-102007 062 919
- DE-A1-102013 105 994
- DE-T5-112014 001 538
- US-A1- 2009 105 848

## Beschreibung

Die Erfindung betrifft ein Feldbusmodul. Die Erfindung betrifft weiterhin ein Feldbussystem. Die Erfindung betrifft weiterhin ein Verfahren zum Betreiben eines Feldbussystems. Diese Patentanmeldung beansprucht die Priorität der deutschen Patentanmeldung 10 2016 110 641.0.

In der Automatisierungstechnik werden Feldbussysteme eingesetzt, um Automatisierungsprozesse in Anlagen mit verteilt angeordneten Komponenten zu steuern. Die Feldbussysteme umfassen einen Feldbus, der eine zentrale Steuereinheit mit meist mehreren, verteilt angeordneten Eingabe-/Ausgabemodule verbindet. An Eingänge der Eingabe-/Ausgabemodule ist die Sensorik, an Ausgänge der Eingabe-/Ausgabemodule die Aktorik des Feldbussystems angeschlossen. Die Sensorik umfasst dabei alle Sensoren, die den Zustand des zu steuernden Automatisierungsprozesses erfassen. Die Aktorik umfasst alle Aktoren, die den Zustand des zu steuernden Prozesses verändern können.

Der Feldbus umfasst in der Regel ein Datenübertragungsmedium, etwa eine Netzwerkverbindung, über welches Daten zwischen der Steuereinheit und den Eingabe-/Ausgabemodulen ausgetauscht werden. Zur Steuerung des Automatisierungsprozesses lesen die Eingabe-/Ausgabemodule über ihre Eingänge Eingangssignale von der Sensorik ein, wobei die Eingangssignale die durch die Sensoren erfassten Messwerte repräsentieren. Die Eingabe-/Ausgabemodule wandeln die Eingangssignale in Eingangsdaten um, die anschließend über den Feldbus an die Steuereinheit übertragen werden. Die Steuereinheit führt eine logische Verknüpfung der Eingangsdaten aus, um Ausgangsdaten zur Steuerung des Automatisierungsprozesses durch die Aktorik zu erzeugen. Die Ausgangsdaten werden über den Feldbus von der Steuereinheit an die Eingabe-/Ausgabemodule übertragen und von den Eingabe-/Ausgabemodule in Ausgangssignale umgewandelt, die über die Ausgänge der Eingabe-/Ausgabemodule ausgegeben werden, um die Aktoren anzusteuern.

Bei Feldbussystemen in sicherheitskritischen Anlagen ist es häufig erforderlich, Ausgänge von Eingabe-/Ausgabemodule in einen sicheren Zustand bringen zu können. Der sichere Zustand ist dabei ein Zustand, bei dem sichergestellt ist, dass die von den Aktoren angetriebenen Teile der Anlage das Bedienpersonal nicht gefährden oder die Anlage nicht beschädigen können. Meist ist der sichere Zustand der Zustand "energielos" bzw. "spannungslos" bzw. "stromlos", bei dem die Aktoren nicht mehr mit Antriebsleistung versorgt werden.

Bei sicherheitskritischen Anlagen muss der Steuervorgang, der die Ausgänge in den sicheren Zustand versetzt, seinerseits sicher ausgeführt werden. Insbesondere muss durch spezielle Schutzmaßnahmen sichergestellt werden, dass der sichere Zustand auch wirklich eingenommen wird und anschließend nicht mehr verlassen wird. In der Regel wird die Aktorik durch spezifische sicherheitstechnische Eingabe-/Ausgabemodule in den sicheren Zustand versetzt.

Druckschrift DE 11 2014 001 538 T5 offenbart ein Feldbussystem mit den Merkmalen der Oberbegriffs des Anspruchs 1, ein Feldbusmodul mit den Merkmalen der Oberbegriffs des Anspruchs 8 und ein Verfahren mit den Merkmalen der Oberbegriffs des Anspruchs 12.

Druckschrift EP 2 778 811 A1 offenbart eine Vorrichtung für ein AS-Interface-System, welche als ein Einspeisemodul eine erste Spannung an eine erstes Kabel und eine zweite Spannung an ein zweites Kabel anlegt. Die Vorrichtung weist ein Abschaltmittel auf, um die erste und die zweite Spannung zeitgleich zu unterbrechen.

Druckschrift DE 10 2013 105 994 A1 offenbart ein Feldgerät mit einem Spannungseingang und einer an dem Spannungseingang angeordneten Überwachungsvorrichtung. Detektiert die Überwachungsvorrichtung einen Spannungsabfall an dem Spannungseingang, wird das Feldgerät heruntergefahren.

Druckschrift DE 10 2007 062 919 A1 offenbart ein Feldgerät mit einem internen Messwiderstand zur Ermittlung eines Schleifenstroms, wobei das Feldgerät über den Schleifenstrom mit Betriebsenergie versorgt wird. Außerdem umfasst das Feldgerät eine Anzeige, die den ermittelten Schleifenstrom anzeigt.

Druckschrift US 2009/0105848 offenbart ein Feldbussystem mit einer redundanten Spannungsversorgung mittels zweier Spannungsversorgungsmodule.

Druckschrift EP 1 312 991 A2 beschreibt ein AS-Interface-System mit einer Überwachungseinrichtung, die Stromschwankungen, die durch Antwortimpulse von Slave-Einheiten auf einem AS-i-Bus verursacht werden, erfasst. Die Überwachungseinrichtung löst ein Schalt- oder Warnsignal aus, wenn die Stromschwankungen einen Schwellwert überschreiten.

Eine Aufgabe der Erfindung ist es, ein verbessertes Verfahren zum Betreiben eines Feldbussystems mit sicherheitskritischen Komponenten bereit zu stellen. Eine weitere Aufgabe der Erfindung ist es, ein verbessertes Feldbussystem zur Steuerung sicherheitskritischer Prozesses zur Verfügung zu stellen. Noch eine Aufgabe der Erfindung ist es, ein verbessertes Feldbusmodul für ein Feldbussystem bereit zu stellen.

Die Aufgaben der Erfindung werden durch ein Feldbussystem mit den Merkmalen des Anspruchs 1, ein Feldbusmodul mit den Merkmalen des Anspruchs 8 und ein Verfahren mit den Merkmalen des Anspruchs 12 gelöst. Bevorzugte Weiterbildungen sind in den abhängigen Ansprüchen angegeben.

Gemäß einem ersten Aspekt wird die Aufgabe gelöst mit einem Feldbussystem, aufweisend:
- eine Schalteinrichtung zum Schalten einer ersten elektrischen Versorgungsspannung und einer zweiten elektrischen Versorgungsspannung,
- eine Steuerungseinrichtung zum Steuern des Schaltens der elektrischen Versorgungsspannungen durch die Schalteinrichtung, wobei die Steuerungseinrichtung über ein Buskontaktsystem an einen Datenbus des Feldbussystems anschaltbar ist, und
- ein Feldbusmodul, das mit einem Anschluss an die erste elektrische Versorgungsspannung, die zweite elektrische Versorgungsspannung und den Datenbus des Feldbussystems anschaltbar ist, wobei
- mittels des Feldbusmoduls ein Wert der ersten elektrischen Versorgungsspannung ermittelbar und über den Datenbus an die Steuerungseinrichtung übermittelbar ist, wobei
- mittels der Steuerungseinrichtung der ermittelte Wert der ersten elektrischen Versorgungsspannung mit einem vorbestimmten Wert der ersten elektrischen Versorgungsspannung vergleichbar ist, wobei
- im Falle, dass der an die Steuerungseinrichtung übermittelte Wert der ersten elektrischen Versorgungsspannung nicht mit dem vorbestimmten Wert der ersten elektrischen Versorgungsspannung übereinstimmt, mittels der Steuerungseinrichtung ein Abschalten der zweiten elektrischen Versorgungsspannung durch die Schalteinrichtung initiierbar ist.

Das Feldbusmodul zur Ermittlung des Wertes der ersten Versorgungsspannung erlaubt es vorteilhafterweise, dass man einen Fehlerfall in einer elektrischen Versorgung von Komponenten des Feldbussystems sicher erkennen kann und das Feldbussystem in einen sicheren Zustand versetzen kann. Dadurch kann beispielsweise ein Fehler erkannt werden, bei dem die Abschaltung der ersten Versorgungsspannung fehlschlägt, zum Beispiel bei einer Überbrückung der beiden elektrischen Versorgungsspannungen, und die an aus der ersten Versorgungsspannung gespeisten Komponenten trotz Abschaltung der ersten Spannungsversorgung noch mit Leistung versorgt werden.

Beispielsweise können Aktoren des Felsbussystems aus der ersten elektrischen Versorgungsspannung und Kommunikationseinheiten und/oder Sensoren des Feldbussystems aus der zweiten elektrischen Versorgungsspannung mit elektrischer Energie versorgt werden. Insbesondere kann es sich bei den Aktoren um sicherheitskritische Komponenten des Feldbussystems handeln. Bei einer getrennten elektrischen Energieversorgung von Kommunikationseinheiten und/oder Sensoren auf der einen und Aktoren auf der anderen Seite, wird insbesondere der technische Vorteil bewirkt, dass zur sicheren Abschaltung der Aktorik die elektrische Energieversorgung der Aktoren gekappt werden kann, womit die Ausgänge automatisch in einen sicheren Zustand versetzt werden. Gleichzeitig kann aufgrund der getrennten Energieversorgung die Funktionalität der Sensorik und/oder der Kommunikation über den Datenbus bestehen bleiben, wodurch ein nicht sicherheitskritischer Rest der Anlage in einen geeigneten Zustand überführt werden kann.

Vorteilhaft ist damit realisierbar, dass als Eingabe-/Ausgabemodule für den Anschluss von Sensoren und/oder Aktoren in dem Feldbussystem Standardkomponenten verwendet werden können, die nicht sicherheitstechnisch ertüchtigt sind und eine kostengünstige Realisierung eines sicherheitskritischen Feldbussystems erlauben. Zudem ist in der Regel die verfügbare Produktpalette an Eingabe-/Ausgabemodulen bei Standardkomponenten wesentlich umfangreicher.

Gemäß einem zweiten Aspekt wird die Aufgabe gelöst mit einem Feldbusmodul für ein eine Steuerungseinrichtung umfassendes Feldbussystem, aufweisend:
- einen Anschluss, mit dem das Feldbusmodul an eine erste elektrische Versorgungsspannung, an eine zweite elektrische Versorgungsspannung und an einen Datenbus des Feldbussystems anschaltbar ist, wobei
- mittels des Feldbusmoduls ein Wert der ersten elektrischen Versorgungsspannung ermittelbar ist, und wobei
- der ermittelte Wert der ersten elektrischen Versorgungsspannung über den Datenbus an die Steuerungseinrichtung des Feldbussystems übermittelbar ist.

Die Übermittlung des Werts der ersten elektrischen Versorgungsspannung an die Steuerungseinrichtung bewirkt insbesondere den technischen Vorteil, dass die Steuerungseinrichtung erkennen kann, dass ein Fehlerfall aufgetreten ist, zum Beispiel in Form einer Überbrückung der beiden elektrischen Versorgungsspannungen. In diesem Fall kann von der Steuerungseinrichtung eine Gesamtabschaltung aller elektrischen Versorgungsspannungen initiiert werden, wodurch das gesamte Feldbussystem in einen sicheren Zustand versetzt werden kann.

Gemäß einem dritten Aspekt wird die Aufgabe gelöst mit einem Verfahren zum Betreiben eines Feldbussystems, aufweisend die Schritte:
- elektrisches Versorgen wenigstens eines Eingabe-/Ausgabemoduls des Feldbussystems mit einer ersten elektrischen Versorgungsspannung und einer zweiten elektrischen Versorgungsspannung,
- Abschalten der ersten elektrischen Versorgungsspannung durch eine Steuerungseinrichtung des Feldbussystems,
- Ermitteln eines Werts der ersten elektrischen Versorgungsspannung mittels eines Feldbusmoduls;
- Übermitteln des ermittelten Werts der ersten elektrischen Versorgungsspannung von dem Feldbusmodul an die Steuerungseinrichtung, und
- Abschalten der zweiten elektrischen Versorgungsspannung durch die Steuerungseinrichtung im Falle, dass der übermittelte Wert der ersten elektrischen Versorgungsspannung nicht mit einem vorbestimmten Wert der ersten elektrischen Versorgungsspannung übereinstimmt.

Dadurch wird insbesondere der Vorteil bewirkt, dass das Abschalten der ersten elektrischen Versorgungsspannung sicher überprüft werden kann. Tritt bei der Abschaltung der ersten elektrischen Versorgungsspannung ein Fehler auf, beispielsweise in Form einer Querspeisung der Leiter für die erste elektrische Versorgungsspannung aus der zweiten elektrischen Versorgungsspannung, so kann dieser Fehler mittels des zurückgemeldeten Werts der ersten elektrischen Versorgungsspannung sicher erkannt und die zweite elektrische Versorgungsspannung ebenfalls abgeschaltet werden.

Bevorzugte Ausführungsformen ergeben sich aus den abhängigen Ansprüchen.

Eine Ausführungsform des Feldbussystems weist ein Eingabe-/Ausgabemodul auf, wobei das Eingabe-/Ausgabemodul einen Anschluss zum Anschluss an die erste und zweite elektrische Spannungsversorgung und zum Anschluss an den Datenbus aufweist. Ferner weist das Eingabe-/Ausgabemodul einen Ausgang zur Ansteuerung eines Aktors auf. Das Eingabe-/Ausgabemodul ist dazu ausgebildet, eine Kommunikationseinrichtung zur Datenkommunikation über den Datenbus mit Energie aus der zweiten elektrischen Spannungsversorgung und den Aktor mit Energie aus der ersten elektrischen Spannungsversorgung zu versorgen. Das Eingabe-/Ausgabemodul ist zwischen der Steuerungseinrichtung und dem Feldbusmodul angeordnet und die erste und zweite elektrische Spannungsversorgung sind der Reihe nach von der Schalteinrichtung über das Eingabe-/Ausgabemodul zu dem Feldbusmodul geführt. Der Datenbus ist der Reihe nach von der Steuerungseinrichtung über das Eingabe-/Ausgabemodul zu dem Feldbusmodul geführt.

Indem das Eingabe-/Ausgabemodul den Aktor und die Kommunikationseinrichtung jeweils aus getrennten Versorgungsspannungen versorgt werden, kann der Aktor vorteilhafterweise durch ein Abschalten der ersten elektrischen Versorgungsspannung stromlos geschaltet werden, während die Kommunikationseinrichtung des Eingabe-/Ausgabemoduls weiterhin mit elektrischer Energie aus der zweiten elektrischen Spannungsversorgung versorgt wird. Dadurch kann selbst bei stromlosen Aktoren noch eine Datenkommunikation auf dem Datenbus aufrechterhalten werden.

Indem das Eingabe-/Ausgabemodul zwischen der Steuerungseinrichtung mit der Schalteinrichtung und dem Feldbusmodul angeordnet ist und die erste und zweite elektrische Spannungsversorgung der Reihe nach von der Schalteinrichtung über das Eingabe-/Ausgabemodul zu dem Feldbusmodul geführt sind, kann vorteilhafterweise die Spannungsversorgung des Eingabe-/Ausgabemoduls durch das Feldbusmodul sicher überwacht werden.

Werden mehrere der Eingabe-/Ausgabemodule an den Datenbus angeschlossen, so kann das Feldbusmodul beispielsweise als letzte Buskomponente nach den Eingabe-/Ausgabemodulen an den Datenbus angeschlossen sein. In diesem Fall befinden sich alle Eingabe-/Ausgabemodule zwischen der Schalteinrichtung und dem Feldbusmodul und die erste und zweite elektrische Spannungsversorgung wird der Reihe nach von der Schalteinrichtung über die Eingabe-/Ausgabemodule zu dem Feldbusmodul geführt werden. Dadurch kann die Versorgung aller Eingabe-/Ausgabemodule mit der ersten elektrischen Versorgungsspannung durch das am Ende des Datenbusses angeordnete Feldbusmodul überwacht werden.

Bei einer Ausführungsform des Feldbussystems ist die erste und zweite elektrische Spannungsversorgung zwischen der Schalteinrichtung und dem Feldbusmodul gemeinsam in einer elektrischen Leitung geführt. Dadurch verringert sich vorteilhafterweise die Anzahl der zwischen der Schalteinrichtung und dem Feldbusmodul zu führenden Leitungen.

Bei einer Ausführungsform des Feldbussystems ist die Steuerungseinrichtung dazu ausgebildet, den Vergleich zwischen dem von dem Feldbusmodul ermittelten Wert der ersten elektrischen Versorgungsspannung und dem vorbestimmten Wert der ersten elektrischen Versorgungsspannung nach einem Abschalten der ersten elektrischen Versorgungsspannung durch die Schalteinrichtung auszuführen. Die Steuerungseinrichtung kann vorteilhafterweise anhand des übermittelten Wertes der ersten elektrischen Versorgungsspannung feststellen, ob nach dem Abschalten der ersten elektrischen Versorgungsspannung die mit der ersten elektrischen Versorgungsspannung versorgten Feldbuskomponenten, insbesondere zwischen der Schalteinrichtung und dem Feldbusmodul angeordnete Eingabe-/Ausgabemodule, auch wirklich stromlos sind.

Bei einer Ausführungsform des Feldbussystems ist die Steuerungseinrichtung dazu ausgebildet, die zweite elektrische Versorgungsspannung abzuschalten, falls nach einem Abschalten der ersten elektrischen Versorgungsspannung durch die Schalteinrichtung nicht innerhalb einer Latenzzeit der von dem Feldbusmodul ermittelte Wert der ersten elektrischen Versorgungsspannung durch die Steuerungseinrichtung empfangen wird. Dadurch wird vorteilhafterweise auch in Fehlerfällen, bei denen die Datenkommunikation zwischen dem Feldbusmodul und der Steuerungseinrichtung gestört ist, eine Abschaltung der zweiten elektrischen Versorgungsspannung gewährleistet.

Bei einer Ausführungsform des Feldbussystems sind das Feldbusmodul und die Steuerungseinrichtung dazu ausgebildet, den von dem Feldbusmodul ermittelten Wert der ersten elektrischen Versorgungsspannung über einen sicheren Datenkanal über den Datenbus zu übertragen. Dadurch wird insbesondere der technische Vorteil bewirkt, dass ein Sicherheitsniveau des gesamten Feldbussystems noch weiter erhöht ist.

Bei einer Ausführungsform des Feldbussystems ist das Feldbusmodul als eine sichere Komponente ausgebildet, um den Wert der ersten elektrischen Versorgungsspannung auf sichere Art und Weise zu erfassen. Auf diese Weise kann eine Störsicherheit des Gesamtsystems nochmals erhöht sein, indem eine Ermittlung des Werts der ersten elektrischen Versorgungsspannung insbesondere redundant durchgeführt wird. Dies kann beispielsweise mit einer erhöhten Anzahl von Ermittlungselementen, wie zum Beispiel Rechnereinrichtungen, Spannungsmesseinrichtungen, usw. durchgeführt werden.

Die Begriffe "sicher" und "Sicherheit", etwa im Zusammenhang mit den Ausdrücken "sichere Komponente", "sicherer Datenkanal", "Erfassung auf sichere Art und Weise" werden im Sinne von Sicherheit verwendet, wie sie in entsprechenden Maschinenrichtlinien, insbesondere der EN IEC 62061:2013-09 und der EN ISO 13849-1:2008 definiert sind. Insbesondere werden die genannten Begriffe dazu verwendet, eine Erkennbarkeit eines Ereignisses oder Zustands (z.B. ob ein Sensor ordnungsgemäß funktioniert, ob eine elektrische Spannung an- oder abgeschaltet ist, usw.) sicherzustellen bzw. einen Vorgang sicher durchzuführen. Insbesondere umfassen die Begriffe "sicher" und "Sicherheit" Einrichtungen und Maßnahmen, die das Auftreten von Fehlern, etwa bei der Erfassung von Messwerten, der Ausgabe von Steuerwerten oder der Übertragung und Verarbeitung der genannten Werte, erkennen und im Fehlerfalle, also beim Auftreten eines Fehlers, geeignete Maßnahmen zur Absicherung des Systems ergreifen. Derartige Maßnahmen können insbesondere ein Abschalten von Antriebsenergie umfassen.

Der Begriff "Zweikanaligkeit" kann in diesem Zusammenhang als ein Weg zur Erreichung von Sicherheit gesehen werden. Zweikanaligkeit und Redundanz können als eine Teilmenge der Begriffe "sichere Betriebsweise" bzw. "Sicherheit" verstanden werden. Beispielsweise erfassen, verarbeiten oder übertragen zweikanalige Systeme Daten, Messwerte oder Steuerwerte mittels zweier paralleler Kanäle. Anschließend können die Ergebnisse der beiden Kanäle verglichen werden, wobei eine Abweichung der Ergebnisse auf einen Fehlerfall hindeutet.

Bei einer Ausführungsform des Feldbusmoduls ist der Anschluss des Feldbusmoduls zur Anschaltung an eine die erste und zweite Versorgungsspannung gemeinsam führende Leitung ausgebildet.

Bei einer Ausführungsform des Feldbusmoduls ist der ermittelte Wert der ersten elektrischen Versorgungsspannung über einen sicheren Datenkanal über den Datenbus an die Steuerungseinrichtung übermittelbar.

Bei einer Ausführungsform des Feldbusmoduls ist der Wert der ersten elektrischen Versorgungsspannung auf sichere Art und Weise ermittelbar.

Eine Weiterbildung des Verfahrens umfasst ein Versorgen eines an das Eingabe-/Ausgabemodul angeschlossenen Aktors mit Energie aus der ersten elektrischen Spannungsversorgung und ein Versorgen einer Kommunikationseinrichtung des Eingabe-/Ausgabemoduls zur Datenkommunikation über den Datenbus mit Energie aus der zweiten elektrischen Spannungsversorgung. Dadurch kann der Aktor vorteilhafterweise durch ein Abschalten der ersten elektrischen Spannungsversorgung stromlos geschaltet werden, während die Kommunikationseinrichtung weiterhin mit Strom versorgt wird. Dies ermöglicht es, auch bei abgeschalteten bzw. stromlosen Aktoren eine Kommunikation über den Datenbus aufrecht zu erhalten und beispielsweise von Eingabe-/Ausgabemodulen erfasste Messwerte über den Datenbus an eine übergeordnete Steuereinheit zu übertragen.

Eine Weiterbildung des Verfahrens umfasst ein Abschalten der zweiten elektrischen Versorgungsspannung durch die Steuerungseinrichtung, falls der von dem Feldbusmodul ermittelte Wert der ersten elektrischen Versorgungsspannung nicht innerhalb einer Latenzzeit nach dem Abschalten der ersten elektrischen Versorgungsspannung an die Steuerungseinrichtung übermittelt wurde.

Bei einer Weiterbildung des Verfahrens werden das Ermitteln des Werts der ersten elektrischen Versorgungsspannung und das Übermitteln des ermittelten Werts der ersten elektrischen Versorgungsspannung an die Steuerungseinrichtung von dem Feldbusmodul in periodischen Abständen wiederholt. Dadurch wird der Steuerungseinrichtung vorteilhafterweise kontinuierlich ein aktueller Wert der ersten elektrischen Versorgungsspannung bereitgestellt, so dass die Steuerungseinrichtung zeitnah auf unerwünschte Abweichungen der an dem Feldbusmodul anliegenden ersten elektrischen Versorgungsspannung reagieren kann.

Die Erfindung wird im Folgenden anhand von Ausführungsbeispielen unter Bezugnahme auf die beigefügten Zeichnungen näher erläutert. Dabei zeigt:
- Fig. 1: ein stark vereinfachtes prinzipielles Blockschaltbild eines erfindungsgemäßen Feldbussystems mit einer Ausführungsform des erfindungsgemäßen Feldbusmoduls, und
- Fig. 2: einen prinzipiellen, stark vereinfachten Ablauf einer Ausführungsform des erfindungsgemäßen Verfahrens.

Eine Kernidee der vorliegenden Erfindung wird darin gesehen, dass mittels eines Feldbusmoduls zur Anordnung am Ende eines sicherheitskritischen Strangs eines Feldbussystems sichergestellt sein soll, dass eine elektrische Versorgung sämtlicher Komponenten des Strangs auf sichere Weise bereitgestellt ist. Dies wird dadurch erreicht, dass eine Auswertung einer elektrischen Versorgungsspannung durchgeführt und quasi in Echtzeit an eine Steuerungseinrichtung übermittelt wird. Von der Steuerungseinrichtung wird eine Überwachung bzw. Auswertung der übermittelten Werte mit tatsächlich geforderten bzw. vorbestimmten Werten durchgeführt. Im Ergebnis können von der Steuerungseinrichtung erforderliche Schritte initiiert werden. Insbesondere kann nach einem Abschalten der Spannungsversorgung von sicherheitskritischen Teilen des Feldbussystems, beispielsweise von sicherheitskritischen Aktoren, durch das Feldbusmodul eine Spannungslosigkeit der Aktoren sicher überwacht werden.

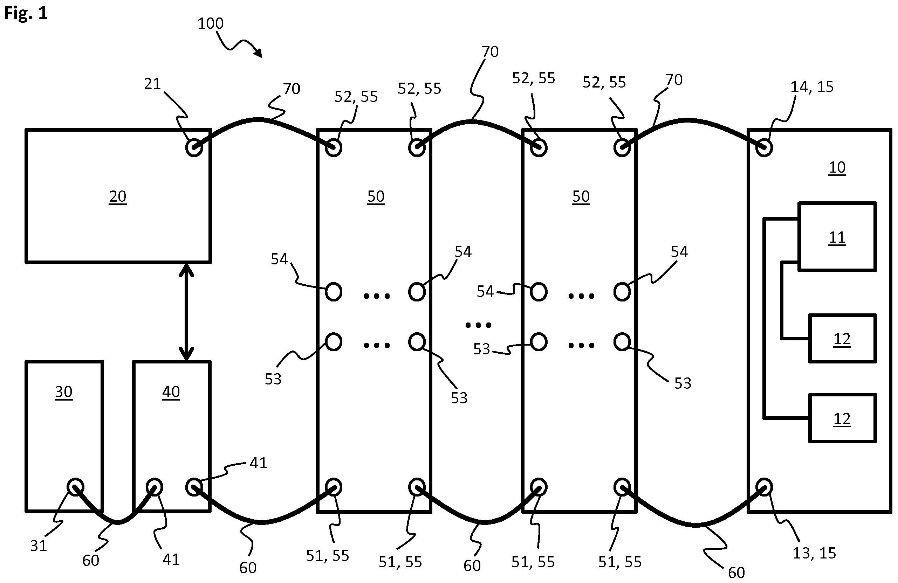

Fig. 1 zeigt ein prinzipielles Übersichtsblockschaltbild einer Ausführungsform eines erfindungsgemäßen Feldbussystems 100. Das Feldbussystem 100 umfasst eine Steuerungseinrichtung 20, einen Datenbus 70, eine definierte Anzahl von Eingabe-/Ausgabemodulen 50 und ein Feldbusmodul 10. Der Datenbus 70 ist in Linientopologie bzw. offener Ringtopologie ausgebildet. Dabei ist die Steuerungseinrichtung 20 am Kopf bzw. Beginn des Datenbusses 70 angeordnet, so dass der Datenbus 70 an der Steuerungseinrichtung 20 beginnt. Nachfolgend sind die Eingabe-/Ausgabemodule 50 der Reihe nach an den Datenbus 70 angeschlossen. Am Ende des Datenbusses 70 ist das Feldbusmodul 10 an den Datenbus 70 angeschlossen.

Die Eingabe-/Ausgabemodule 50 verfügen über einen oder mehrere Eingänge 54 zum Anschluss von in Fig. 1 nicht dargestellten Sensoren und über einen oder mehrere Ausgänge 53 zum Anschluss von, ebenfalls nicht dargestellten, Aktoren. Bei alternativen Ausrührungsformen des Feldbussystems 100 können die Eingabe-/Ausgabemodule 50 auch lediglich einen oder mehrere Eingänge und keine Ausgänge oder lediglich einen oder mehrere Ausgänge und keine Eingänge aufweisen. Die Eingänge 54 und/oder Ausgänge 53 können als digitale oder analoge Eingänge bzw. Ausgänge ausgebildet sein, welche beispielsweise eine Spannung einlesen bzw. bereitstellen. Die Ausgänge 53 können auch als Motoransteuerungen ausgebildet sein, die einen geregelten Strom für einen elektrischen Motor bereitstellen, beispielsweise zur Erzeugung hoher Antriebsleistung.

Bei den Sensoren kann es sich beispielswiese um Temperatur-, Druck- oder Kontaktsensoren oder um Lichtschranken handeln. Die Sensoren können auch sicherheitskritische Zustände des Automatisierungsprozesses erfassen. Dabei können sie beispielsweise erfassen, ob eine Schutztür der gesteuerten Anlage geöffnet wurde oder ein Not-Aus-Schalter der Anlage betätigt wurde.

Bei den Aktoren kann es sich beispielsweise um Relais, elektrisch gesteuerte Ventile oder um Elektromotoren handeln. Die Aktoren können auch Teile der Anlage bewegen, von denen eine Sicherheitsgefährdung ausgehen kann, beispielsweise eine Gefährdung von Bedienpersonal oder die Gefahr einer Beschädigung der Anlage. Beispielsweise können die Aktoren Roboter oder Pressen betätigen oder Heizelemente steuern.

Die Eingabe-/Ausgabemodule 50 sind dazu ausgebildet, über den Datenbus 70 Eingangsdaten an eine nicht dargestellte übergeordnete Steuereinheit zu senden und Ausgangsdaten von der übergeordneten Steuereinheit zu empfangen. Die Eingangs- und Ausgangsdaten bilden insgesamt Prozessdaten zur Steuerung des Automatisierungsprozesses.

Der Datenbus 70 kann als ein Feldbus ausgebildet sein. Der Datenbus 70 kann auf dem Ethernet-Protokoll basieren oder aufsetzen. Der Datenbus 70 kann als ein echtzeitfähiger Datenbus ausgebildet sein, bei dem eine Datenübermittlung zwischen zwei an den Datenbus 70 angeschlossenen Einheiten bzw. Modulen innerhalb eines vorgegebenen Zeitintervalls erfolgt und abgeschlossen ist. Insbesondere kann der Datenbus 70 auf dem EtherCAT-Protokoll, dem Profibus-Protokoll oder dem Interbus-Protokoll basieren.

Zum Datenaustausch kann von der Steuerungseinrichtung 20 ausgehend ein Datenpaket über den Datenbus 70 übertragen werden, in dem die Ausgangsdaten für die Eingabe-/Ausgabemodule 50 enthalten sind. Das Datenpaket kann auf dem Datenbus 70 die Eingabe-/Ausgabemodule 50 der Reihe nach durchlaufen, wobei die Eingabe-/Ausgabemodule 50 jeweils dem Datenpaket die für sie bestimmten Ausgangsdaten entnehmen und die von ihnen erzeugten Eingangsdaten in das Datenpaket einfügen. Nachdem das Datenpaket das am Ende des Datenbusses 70 angeordnete Feldbusmodul 10 erreicht hat, kann es auf dem Datenbus 70 die Eingabe-/Ausgabemodule 50 in umgekehrter Reihenfolge zurück zur Steuerungseinrichtung 20 durchlaufen.

Das in Figur 1 dargestellte Feldbussystem 100 kann Teil eines größeren Steuerungssystems sein. Das Steuerungssystem kann die übergeordnete Steuereinheit zur Steuerung des Automatisierungsprozesses umfassen. Im Rahmen der Steuerung kann die übergeordnete Steuereinheit die Eingangsdaten logisch verknüpfen und die Ausgangsdaten erzeugen. Die übergeordnete Steuereinheit kann die Eingangs- und Ausgangsdaten mit der Steuerungseinrichtung 20 austauschen, beispielsweise über einen nicht dargestellten weiteren Datenbus. Dabei können der weitere Datenbus und der Datenbus 70 auch einen gemeinsamen bzw. zusammenhängenden Datenbus bilden.

Beispielsweise kann die übergeordnete Steuereinheit ein Datenpaket erzeugen, welches zunächst zu der Steuerungseinrichtung 20 und anschließend zu den Eingabe-/Ausgabemodule 50 und dem Feldbusmodul 10 übertragen wird. Alternativ kann auch die Steuerungseinrichtung 20 dazu ausgebildet sein, ein Datenpaket zur Übertragung der Eingangs- und Ausgangsdaten erzeugen. Alternativ oder zusätzlich kann die Steuerungseinrichtung 20 auch dazu ausgebildet sein, den Automatisierungsprozess vollständig oder teilweise zu steuern, indem sie Eingangsdaten logisch verknüpft und Ausgangsdaten erstellt. In diesem Fall kann die übergeordnete Steuereinheit in der Steuerungseinrichtung 20 angeordnet sein.

Die Steuerungseinrichtung 20 ist funktional mit einer Schalteinrichtung 40 verbunden. Eine elektrische Versorgungseinrichtung 30 versorgt über einen Ausgang 31 mehrere Komponenten des Feldbussystems 100 mit zwei unterschiedlichen elektrischen Versorgungsspannungen U_{P}, U_{S}. Dabei werden eine erste elektrische Versorgungsspannung U_{P} und eine zweite elektrische Versorgungsspannung U_{S} der Reihe nach von dem Ausgang 31 der Versorgungseinrichtung 30 an die Schalteinrichtung 40, an die Eingabe-/Ausgabemodule 50 und an das Feldbusmodul 10 geführt.

Das Feldbusmodul 10 weist einen Anschluss 15 zum Anschluss an die erste elektrische Versorgungsspannung U_{P}, die zweite elektrische Versorgungsspannung U_{S} und den Datenbus 70 auf. Der Anschluss 15 umfasst ein Buskontaktsystem 14, über das die Signale des Datenbusses 70 übertragen werden, und ein Spannungskontaktsystem 13, über das die erste und zweite elektrische Versorgungsspannung U_{P}, U_{S} übertragen werden.

Mit dem Spannungskontaktsystem 13 ist das Feldbusmodul 10 an eine elektrische Leitung 60 angeschlossen, welches sowohl die erste elektrische Versorgungsspannung U_{P}, als auch die zweite elektrische Versorgungsspannung U_{S} führt. Die elektrische Leitung 60 kann mehrere voneinander isolierte elektrische Leiter umfassen. Beispielsweise können die Leiter in einer gemeinsamen Ummantelung zusammengefasst sein. Alternativ oder zusätzlich kann die elektrische Leitung 60 und die Anschlüsse 15, 55 auch unter Verwendung von Steckverbindern zwischen den Eingabe-/Ausgabemodulen 50 und dem Feldbusmodul 10 realisiert sein. Beispielsweise können jeweils an den Außenseiten der Eingabe-/Ausgabemodule 50 und des Feldbusmoduls 10 Steckverbinder derart angeordnet sein, dass die Steckverbinder bei einer an einander anschließenden Anordnung der Module, etwa auf einer Hutschiene oder Klemmleiste, elektrisch leitend miteinander verbunden werden. Die elektrische Leitung 60 kann zwischen den einzelnen Modulen auch mit voneinander verschiedenen Verbindungstechniken, etwa sowohl mit in einer gemeinsamen Ummantelung zusammengefassten Leitern, als auch mit Steckverbindern, realisiert sein.

Die erste und die zweite elektrische Versorgungsspannung U_{P}, U_{S} können jeweils auf getrennten Leitern bzw. Adern der elektrischen Leitung 60 übertragen werden. Beispielsweise können die erste und die zweite elektrische Versorgungsspannung U_{P}, U_{S} jeweils auf galvanisch getrennten Leiterpaaren übertragen werden, wobei jeweils ein Leiter der Leiterpaare einen Masseleiter darstellt. Für den Anschluss an die Leitung 60 kann das Spannungskontaktsystem 13 je einen Kontakt pro Leiter, beispielsweise vier Kontakte umfassen.

Mit dem Buskontaktsystem 14 ist das Feldbusmodul 10 an den Datenbus 70 angeschlossen. Für die Datenübertragung kann der Datenbus 70 mehrere Leiter umfassen. Insbesondere kann der Datenbus 70 für die Datenübertragung ein oder mehrere Leiterpaare umfassen. Beispielsweise kann der Datenbus 70 zwei differentielle Leiterpaare umfassen, welche beispielsweise als Rx+/Rx- und Tx+/Tx- bezeichnet sein können. Das Buskontaktsystem 14 kann je Leiter je einen Kontakt aufweisen, beispielsweise kann das Buskontaktsystem 14 für den Anschluss von zwei Leiterpaaren insgesamt vier Kontakte umfassen.

Die Kontakte des Spannungskontaktsystems 13 des Anschlusses 15 und des Buskontaktsystems 14 des Anschlusses 15 können jeweils in getrennten Kontakteinheiten, etwa in getrennten Steckverbindern, an dem Feldbusmodul 10 angeordnet sein. Bei einer alternativen Ausführungsform des Feldbussystems 100 und des Anschlusses 15 können auch die Kontakte des Spannungskontaktsystems 13 für die erste elektrische Versorgungsspannung U_{P}, die Kontakte des Spannungskontaktsystems 13 für die zweite elektrische Versorgungsspannung U_{S} und die Kontakte des Buskontaktsystems 14 jeweils in separaten Kontakteinheiten angeordnet sein. Bei einer weiteren alternativen Ausführungsform des Feldbussystems 100 und des Feldbusmoduls 10 können die Kontakte des Anschlusses 15, also sowohl die Kontakte des Spannungskontaktsystems 13, als auch die Kontakte des Buskontaktsystems 14, auch zusammengefasst in einer Kontakteinheit an dem Feldbusmodul 10 ausgebildet sein. Beispielswiese können die Leiter der elektrischen Leitung 60 und des Datenbusses 70 in einer gemeinsamen Ummantelung geführt und an die gemeinsame Kontakteinheit angeschlossen sein.

Bei einer alternativen Ausführungsform des Feldbussystems 100 und des Feldbusmoduls 10 können für den Datenbus 70 und die elektrische Leitung 60 dieselben Leiter der Leitung genutzt werden. Beispielsweise kann der Datenbus 70 für die Datenübertragung zwei Leiterpaare, etwa ein (Rx+/Rx-)-Leiterpaar und ein (Tx+/Tx-)-Leiterpaar, umfassen, und es kann die erste Versorgungsspannung U_{P} über das eine der Leiterpaare und die zweite elektrische Versorgungsspannung U_{S} über das andere der Leiterpaare übertragen werden. In diesem Fall kann der Anschluss 15 des Feldbusmoduls eine Kontakteinheit mit vier Kontakten umfassen, an welche die vier Leiter der beiden Leiterpaare angeschlossen werden.

Innerhalb des Feldbusmoduls 10 können die an den Kontakten anliegenden Signale des Datenbusses 70 und die ebenfalls an den Kontakten anliegende erste und zweite Spannungsversorgung U_{P}, U_{S} beispielsweise mittels eines Hochpassfilters für die Signale des Datenbusses 70 und eines Tiefpassfilters für die erste und zweite Spannungsversorgung U_{P}, U_{S} voneinander getrennt werden. Die Signale des Datenbusses 70 und die erste und zweite Versorgungsspannung U_{P}, U_{S} können beispielsweise gemäß dem EtherCAT P Standard zusammen auf Leitern einer gemeinsamen Leitung mit einer gemeinsamen Ummantelung, welche den Datenbus 70 und die Leitung 60 umfasst, geführt werden.

Die Eingabe-/Ausgabemodule 50 weisen einen Anschluss 55 auf, mit dem sie an den Datenbus 70, an die erste Spannungsversorgung U_{P} und an die zweite Spannungsversorgung U_{S} angeschlossen sind. Der Anschluss 55 der Eingabe-/Ausgabemodule 50 ist ausgebildet wie der Anschluss 15 des Feldbusmoduls. Insbesondere umfasst der Anschluss 55 ein Spannungskontaktsystem 51, das ausgebildet ist wie das Spannungskontaktsystem 13 des Feldbusmoduls 10, und ein Buskontaktsystem 52, das ausgebildet ist wie das Buskontaktsystem 14 des Feldbusmoduls 10. Das Spannungskontaktsystem 51 und das Buskontaktsystem 52 können insbesondere eine oder mehrere Kontakteinheiten mit jeweils einem oder mehreren Kontakten umfassen.

Die Steuerungseinrichtung 20 ist über ein Buskontaktsystem 21 an den Datenbus 70 angeschlossen. Das Buskontaktsystem 21 der Steuerungseinrichtung 20 kann ausgebildet sein wie die Buskontaktsysteme 52, 14 der Eingabe-/Ausgabeeinheiten 50 und/oder des Feldbusmoduls 10. Die Schalteinrichtung 40 ist über ein Spannungskontaktsystem 41 an den Ausgang 31 der Versorgungseinrichtung 30 und an die Leitung 60 angeschlossen. Das Spannungskontaktsystem 41 der Schalteinrichtung 40 kann ausgebildet sein wie die Spannungskontaktsysteme 51, 13 der Eingabe-/Ausgabeeinheiten 50 und/oder des Feldbusmoduls 10.

Die Steuerungseinrichtung 20 und die Schalteinrichtung 40 können in einem gemeinsamen Gehäuse angeordnet sein. Das Spannungskontaktsystem 41 der Schalteinrichtung 40 und das Buskontaktsystem 21 der Steuerungseinrichtung 20 können zusammen ausgebildet sein wie die Anschlüsse 51, 52 der Eingabe-/Ausgabeeinheiten 50 und/oder der Anschluss 15 des Feldbusmoduls 10.

Zur Übertragung der Daten über den Datenbus 70 verfügen die Eingabe-/Ausgabemodule 50, das Feldbusmodul 10 und die Steuerungseinrichtung 20 über Kommunikationseinrichtungen, welche über die Buskontaktsysteme 21, 52, 14 mit dem Datenbus 70 verbunden sind. Die Kommunikationseinrichtungen können beispielsweise Protokollchips umfassen, welche ein für die Kommunikation auf dem Feldbus genutztes Protokoll implementieren. Beispielsweise können die Kommunikationseinrichtungen EtherCAT-Protokollchips umfassen.

Die erste elektrische Versorgungsspannung U_{P} wird für die elektrische Versorgung der an die Ausgänge 53 der Eingabe-/Ausgabemodule 50 angeschlossenen Aktorik und die zweite elektrische Versorgungsspannung U_{S} für die elektrische Versorgung der an die Eingänge 54 der Eingabe-/Ausgabemodule 50 angeschlossenen Sensorik bereitgestellt. Zusätzlich oder alternativ können auch die Kommunikationseinrichtungen der Eingabe-/Ausgabemodule 50, welche den Austausch der Prozessdaten über den Datenbus 70 steuern, und/oder Rechnereinheiten der Eingabe-/Ausgabemodule 50, welche unter anderem die Umwandlung zwischen den Eingangs- und Ausgangssignalen und den Prozessdaten vornehmen, aus der zweiten elektrischen Versorgungsspannung U_{S} mit elektrischer Energie versorgt werden. Die zweite elektrische Versorgungsspannung U_{S} kann auch nur die Kommunikationseinrichtungen und/oder die Rechnereinheiten speisen, während die Sensorik aus einer anderen Spannungsquelle versorgt wird.

Für die elektrischen Versorgungsspannungen U_{P}, U_{S} können elektrische Sicherheitskleinspannungen mit einem Spannungspegel von kleiner als 150V verwendet werden, beispielsweise mit jeweils 48V oder 24V für beide elektrischen Versorgungsspannungen U_{P}, U_{S} oder 48V für die erste elektrische Versorgungsspannung U_{P} und 24V für die zweite elektrische Versorgungsspannung U_{S}.

Über die Ausgänge 53 der Eingabe-/Ausgabemodule 50 sind sicherheitskritische Aktoren, wie zum Beispiel Maschinen bzw. Fertigungsautomaten mit Schutztüren, die im laufenden Betrieb der Anlagen stets geschlossen sein müssen, mit der ersten elektrischen Versorgungsspannung U_{P} angesteuert. Damit bildet der in Figur 1 dargestellte Teil des Datenbusses 70 zwischen der Steuerungseinrichtung 20 mit der Schalteinrichtung 40 und dem Feldbusmodul 10 insgesamt einen sicherheitskritischen Strang des Feldbussystems 100. Bei Eintritt eines sicherheitskritischen Ereignisses, beispielsweise bei Öffnen einer die Anlage sichernden Schutztüre oder bei Betätigung eines Not-Aus-Schalters, muss sichergestellt werden, dass die sicherheitskritischen Aktoren in einen sicheren, beispielsweise einen stromlosen, Zustand überführt werden.

Die Steuerungseinrichtung 20 kann beispielsweise als eine sichere Steuerungseinrichtung ausgebildet sein und als solche eine sichere Komponente des Feldbussystems 100 darstellen. Insbesondere kann die Steuerungseinrichtung 20 dazu ausgebildet sein, Fehler in den an sie übermittelten Daten zu erkennen und eine fehlerfreie Verarbeitung und Ausgabe von Daten zu gewährleisten. Hierzu kann die Steuerungseinrichtung 20 beispielsweise über redundante Verarbeitungskanäle verfügen, deren Ergebnisse miteinander verglichen werden. Insbesondere kann die Steuerungseinrichtung 20 den Normen IEC 62061, ISO 13849-1 und/oder IEC 61508 genügen.

Die Steuerungseinrichtung 20 ist dafür vorgesehen, die Schalteinrichtung 40 auf sichere Weise zu steuern, wobei eine sichere An- und Abschaltung der elektrischen Versorgungsspannungen U_{P}, U_{S} durchgeführt wird. Dabei kann insbesondere die Steuerung der Abschaltung mittels sicherer Komponenten, beispielsweise über redundante Verarbeitungskanäle erfolgen. Es kann auch eine Schalterstellung zur Abschaltung der Versorgungsspannungen U_{P}, U_{S} erfasst und an die Steuerungseinrichtung 20 zurückgemeldet werden, beispielsweise über redundante Verarbeitungs- und Signalkanäle.

Die sichere An- und Abschaltung der elektrischen Versorgungsspannungen U_{P}, U_{S} sieht vor, dass beim Eintreten eines sicherheitsrelevanten Ereignisses (zum Beispiel beim Öffnen einer Schutztüre eines Fertigungsautomaten) zunächst die erste elektrische Versorgungsspannung U_{P} für die Aktoren des Systems abgeschaltet wird. Dabei bleibt die zweite elektrische Versorgungsspannung U_{S} für die Sensoren noch angeschaltet, um ein Systemverhalten des Feldbussystems 100 über die angeschlossene Sensorik (nicht dargestellt) weiterhin beobachten bzw. überwachen zu können.

Das Abschalten der ersten elektrischen Versorgungsspannung U_{P} kann dabei ausgelöst werden als eine Reaktion auf Prozessdaten, welche den Eintritt des sicherheitskritischen Ereignisses signalisieren. Die Prozessdaten können dabei von Eingabe-/Ausgabemodulen 50 erzeugt werden, die in dem in Figur 1 dargestellten Strang des Feldbussystems 100, oder aber in einem in Figur 1 nicht dargestellten Teil des Feldbussystems 100 angeordnet sind.

Durch das Abschalten der ersten elektrischen Versorgungsspannung U_{P} werden die Ausgänge 53 der Eingabe-/Ausgabemodule 50 und die an die Ausgänge 53 angeschlossenen Aktoren stromlos geschaltet. Die über das Feldbussystem 100 gesteuerte Anlage kann derart ausgebildet sein, dass der sichere Zustand der Anlage der stromlose Zustand der Aktoren ist. In diesem Fall wird die Anlage durch das sichere Abschalten der ersten elektrischen Versorgungsspannung U_{P} grundsätzlich in den sicheren Zustand überführt.

Damit das sichere Abschalten der ersten elektrischen Versorgungsspannung U_{P} durch die Steuerungseinrichtung 20 und die Schalteinrichtung 40 auch zuverlässig den sicheren Zustand der Anlage zur Folge hat, muss jedoch sichergestellt sein, dass nach dem Abschalten der ersten elektrischen Versorgungsspannung U_{P} die die erste elektrische Versorgungsspannung U_{P} führenden Teile der Leitung 60 auch wirklich spannungslos sind.

Im Betrieb des Feldbussystems 100 kann es vor oder nach dem Abschalten der ersten elektrischen Versorgungsspannung U_{P} allerdings vorkommen, dass eine Beschädigung der Leitung 60 eintritt mit der Folge, dass eine bereits abgeschaltete erste elektrische Versorgungsspannung U_{P} von der zweiten elektrischen Versorgungsspannung U_{S} in unerwünschter Weise elektrisch kurzgeschlossen bzw. quergespeist wird, wie es bei einer schadhaften Leitung 60 aufgrund von äußerer mechanischer Einwirkung auf die Leitung 60 der Fall sein kann.

Auch können Fehler oder Beschädigungen in den Eingabe-/Ausgabemodulen 50 dazu führen, dass die Teile der Leitung 60, die die erste elektrische Versorgungsspannung U_{P} führen, auch bei abgeschalteter erster elektrischer Versorgungsspannung U_{P} mit einer Spannung beaufschlagt werden, beispielsweise indem die betreffenden Teile der Leitung 60 aus der zweiten elektrischen Versorgungsspannung U_{S} quergespeist werden. In diesen Fällen ist trotz abgeschalteter erster elektrischer Versorgungsspannung U_{P} ein Spannungspegel auf den Leitern der ersten elektrischen Versorgungsspannung U_{P} vorhanden, was unerwünschte und sicherheitskritische Effekte an der angeschlossenen Aktorik bewirken kann.

Zur Erkennung dieser Fehlerfälle ist am Ende des sicherheitskritischen Strangs des Feldbussystems 100 das Feldbusmodul 10 in das System geschaltet, das eine Überwachungsfunktion für die genannte erste elektrische Versorgungsspannung U_{P} übernimmt, wie nachfolgend näher erläutert ist. Das Feldbusmodul 10 ist für eine Detektion bzw. Ermittlung eines Aktualwerts der ersten elektrischen Versorgungsspannung U_{P} vorgesehen. Das Feldbusmodul 10 weist eine Spannungsmesseinrichtung 12 auf, welche dazu ausgebildet ist, den Wert der an dem Spannungskontaktsystem 13 des Feldbusmoduls 10 anliegenden ersten elektrischen Versorgungsspannung U_{P} zu messen. Die Spannungsmesseinrichtung 12 kann beispielsweise als ein Analog/Digital-Wandler oder als ein Komparator ausgebildet sein.

Das Feldbusmodul 10 ist weiter dazu ausgebildet, den von der Spannungsmesseinrichtung 12 ermittelten Wert der ersten elektrischen Versorgungsspannung U_{P} an die Steuerungseinrichtung 20 zurückzumelden. Das Feldbusmodul 10 verfügt über eine Rechnereinrichtung 11, beispielsweise in Form eines Mikroprozessors oder eines FPGAs, welche ein von der Spannungsmesseinrichtung 12 übertragenes Signal empfängt und in den ermittelten Spannungswert repräsentierende Informationsdaten umwandelt.

Der Wert der von dem Feldbusmodul 10 ermittelten ersten elektrischen Versorgungsspannung U_{P} wird über den Datenbus 70 an die Steuerungseinrichtung 20 übermittelt. Hierzu umfasst das Feldbusmodul 10 eine, in Figur 1 nicht dargestellte, Kommunikationseinrichtung, welche die Anschaltung an den Datenbus 70 vermittelt. Die Kommunikationseinrichtung des Feldbusmoduls 10 kann ausgebildet sein wie die Kommunikationseinrichtungen der Eingabe-/Ausgabeeinheiten 50. Die Kommunikationseinrichtung und die für die Ermittlung des Wertes der ersten elektrischen Versorgungsspannung U_{P} benötigten Komponenten des Feldbusmoduls 10, also beispielsweise die Rechnereinrichtung 11 und die Spannungsmesseinrichtung 12, werden aus der an dem Spannungskontaktsystem 13 anliegenden zweiten elektrischen Versorgungsspannung U_{S} mit elektrischer Energie versorgt.

Die Kommunikationseinrichtung kann beispielsweise dazu ausgebildet sein, die den ermittelten Wert der ersten elektrischen Versorgungsspannung repräsentierenden Informationsdaten in das auf dem Datenbus 70 umlaufende Datenpaket einzufügen. Bei dem Datenpaket kann es sich beispielsweise um ein Datentelegramm, etwa ein EtherCAT-Datentelegramm halten. Beispielsweise kann die Kommunikationseinrichtung einen EtherCAT-Protokollchip umfassen.

Die Steuerungseinrichtung 20 ist dazu ausgebildet, zu den von dem Feldbusmodul 10 übermittelten Wert der ersten elektrischen Versorgungsspannung U_{P} mit einem vorbestimmten Wert der ersten elektrischen Versorgungspannung U_{P} zu vergleichen. Insbesondere kann die Steuerungseinrichtung 20 dazu ausgebildet sein, zu überprüfen, ob der übermittelte Wert der ersten elektrischen Versorgungsspannung U_{P} mit dem vorbestimmten Wert der ersten elektrischen Versorgungspannung U_{P} übereinstimmt. Der vorbestimmte Wert der ersten elektrischen Versorgungsspannung U_{P} kann dabei insbesondere abhängig sein von einem Schaltzustand der Schalteinrichtung 40. Erwartet wird also bei einem durchgeführten Abschalten, dass die erste elektrische Versorgungsspannung U_{P} am Spannungskontaktsystem 13 des Feldbusmoduls 10 nicht mehr anliegt, der vorbestimmte Wert also Null ist.

Bei einer geöffneten Stellung der Schalteinrichtung 40 kann der vorbestimmte Wert der durch die elektrische Versorgungseinrichtung 30 bereitgestellte Spannungswert der ersten elektrischen Versorgungsspannung U_{P} sein. Dabei kann der vorbestimmte Wert auch um einen Differenzbetrag geringer sein als der durch die elektrische Versorgungseinrichtung 30 bereitgestellte Spannungswert, etwa um Spannungsverluste durch einen Leitungswiderstand zwischen der elektrischen Versorgungseinrichtung 30 und dem Feldbusmodul 10 zu berücksichtigen.

Entspricht der durch das Feldbusmodul 10 übermittelte Wert nicht dem vorbestimmten Wert der ersten elektrischen Versorgungsspannung U_{P}, wird ein Fehlerfall angenommen, der zum Beispiel nach einem Abschalten der ersten elektrischen Versorgungsspannung U_{P} in Form der vorgenannten Querspeisung der Leiter für die erste elektrische Versorgungsspannung U_{P} der Leitung 60 vorliegen kann. Die Steuerungseinrichtung 20 initiiert im Fehlerfall eine Abschaltung der zweiten elektrischen Versorgungsspannung U_{S}, damit diese nicht weiter die Leiter für die erste elektrische Versorgungsspannung U_{P} querspeisen kann. Im Ergebnis wird damit die ganze elektrische Versorgung für alle Eingabe-/Ausgabemodule 50 des Feldbussystems 100 abgeschaltet, wodurch das System in einen sicheren, d.h. energielosen bzw. stromlosen bzw. spannungslosen Zustand versetzt wird.

Ist hingegen der über den Datenbus 70 übermittelte Wert der ersten elektrischen Versorgungsspannung U_{P} nach einem Abschalten der ersten elektrischen Versorgungsspannung U_{P} durch die Schalteinrichtung 40 identisch mit dem erwarteten Wert der ersten elektrischen Versorgungsspannung U_{P}, das heißt, dass ein ordnungsgemäßes Abschalten der ersten elektrischen Versorgungsspannung U_{P} stattgefunden hat, so wird keine Änderung der elektrischen Einspeisung des Feldbussystems 100 vorgenommen. Dies bedeutet, dass die zweite elektrische Versorgungsspannung U_{S} auch nach dem Abschalten der ersten elektrischen Versorgungsspannung U_{P} durch die Schalteinrichtung 40 weiterhin angeschaltet bleibt.

Das Feldbusmodul 10 kann dazu ausgebildet sein, den Wert der ersten elektrischen Versorgungsspannung U_{P} periodisch in festen Zeitintervallen an die Steuerungseinrichtung 20 zu übermitteln. Alternativ kann das Feldbusmodul 10 auch dazu ausgebildet sein, den Wert der ersten elektrischen Versorgungsspannung U_{P} ereignisgesteuert an die Steuerungseinrichtung 20 zu übermitteln, beispielsweise nach einem Abfall der ersten elektrischen Versorgungsspannung U_{P} unter einen vorgegebenen Grenzwert.

Das Übermitteln des Werts der ersten elektrischen Versorgungsspannung U_{P} an die Steuerungseinrichtung 20 kann auf sichere Weise erfolgen, sodass Fehler bei der Übermittlung des Werts der ersten elektrischen Versorgungsspannung U_{P} an die Steuerungseinrichtung 20 sicher erkannt werden können. Dabei kann die Übertragung des Werts der ersten elektrischen Versorgungsspannung U_{P} beispielsweise über einen auf dem Datenbus 70 realisierten sicheren Übertragungskanal erfolgen.

Beispielsweise können das Feldbusmodul 10 und die Steuerungseinrichtung 20 jeweils Sicherheitskomponenten aufweisen, welche den sicheren Übertragungskanal realisieren. Die Sicherheitskomponenten können beispielsweise ein Sicherheitsprotokoll zur Erkennung einer fehlerhaften oder ausbleibenden Übertragung des Wertes der ersten elektrischen Versorgungsspannung U_{P} über den Datenbus 70 implementieren. Bei dem Sicherheitsprotokoll kann es sich beispielsweise um das Protokoll Failsafe over EtherCAT (FSoE) oder das Protokoll PROFIsafe handeln. Alternativ oder zusätzlich kann der von dem Feldbusmodul 10 ermittelte Wert anstatt über den Datenbus 70 auch über ein separat geführtes Datenkabel übertragen werden.

Die Steuerungseinrichtung 20 kann dazu ausgebildet sein, den von dem Feldbusmodul 10 übermittelten Wert der ersten elektrischen Versorgungsspannung U_{P} bei angeschalteter erster elektrischer Versorgungsspannung U_{P} mit dem vorbestimmten Wert zu vergleichen. Dabei kann beispielsweise durch die Steuerungseinrichtung 20 überprüft werden, dass die erste elektrische Versorgungsspannung U_{P} nicht unter einen Wert fällt, unterhalb dem die an die Eingabe-/Ausgabemodule 50 angeschlossenen Aktoren nicht mehr sicher bzw. zuverlässig betrieben werden können. Die Steuerungseinrichtung 20 kann dazu ausgebildet sein, die erste elektrische Versorgungspannung U_{P} und/oder die zweite elektrische Versorgungsspannung U_{S} abzuschalten, falls sich bei dem Vergleich ein derart niedriger Wert der ersten elektrischen Versorgungsspannung U_{P} ergibt.

Das Feldbusmodul 10 kann dazu ausgebildet sein, neben der ersten elektrischen Versorgungsspannung U_{P} auch die zweite elektrische Versorgungsspannung U_{S} zu messen und deren Wert an die Steuerungseinrichtung 20 zu übermitteln. Dadurch kann die Steuerungseinrichtung 20 auch einen Abfall der zweiten elektrischen Versorgungsspannung U_{S} detektieren. Fällt die zweite elektrische Versorgungsspannung U_{S} unter einen kritischen Wert, beispielsweise auf Werte, bei denen ein zuverlässiger Betrieb der Sensoren und/oder eine zuverlässige Datenkommunikation über den Datenbus 70 nicht mehr gewährleistet ist, kann die Steuerungseinrichtung 20 die Aktoren in einen sicheren Zustand versetzen, indem sie über die Schalteinrichtung 40 die erste und/oder zweite elektrische Versorgungsspannung U_{P}, U_{S} abschaltet.

Im Ergebnis ist es damit möglich, dass für die Eingabe-/Ausgabemodule 50 kostengünstige Standardmodule verwendet werden können, die keine aufwendige sicherheitstechnische Aufrüstung erfordern.

Im Ergebnis ist dadurch eine kostengünstige Realisierung eines sicherheitskritischen Feldbussystemstrangs unterstützt.

Im Ergebnis sind auf diese Weise unterschiedliche Sicherheitsniveaus für das gesamte sicherheitskritische Feldbussystem 100 und/oder für ein das Feldbussystem 100 umfassendes größeres Feldbussystem möglich.

Ein weiter erhöhtes Sicherheitsniveau kann dadurch realisiert werden, dass mittels des Feldbusmoduls 10 auch die Ermittlung der ersten elektrischen Versorgungsspannung U_{P} auf sichere Art und Weise durchgeführt wird. Dies kann beispielsweise dadurch erfolgen, dass das Feldbusmodul 10 als eine sichere Komponente des Feldbussystems 100 ausgebildet ist und beispielsweise eine redundante Anordnung mehrerer Rechnereinrichtungen 11 und/oder Spannungsmesseinrichtungen 12 zur Messung der ersten elektrischen Versorgungsspannung U_{P} aufweist. Alternativ kann eine Redundanz innerhalb des Feldbusmoduls 10 auch durch eine redundante mehrkanalige Softwarearchitektur zur Verarbeitung der Messwerte und zur Erzeugung der an die Steuerungseinrichtung 20 zu übermittelten Daten realisiert werden.

Dadurch kann bei größtmöglichem Sicherheitsniveau eine sichere Erfassung und Übertragung eines sicher ermittelten Werts der ersten elektrischen Versorgungsspannung U_{P} an die Steuerungseinrichtung 20 erfolgen.

Es kann vorgesehen sein, eine Latenzzeit zu definieren bzw. variabel zu gestalten, innerhalb derer seit dem Abschalten der ersten elektrischen Versorgungsspannung U_{P} der Wert der ermittelten ersten elektrischen Versorgungsspannung U_{P} vom Feldbusmodul 10 an die Steuerungseinrichtung 20 übermittelt sein muss. Empfängt die Steuerungseinrichtung 20 nach dem Abschalten der ersten elektrischen Versorgungsspannung U_{P} innerhalb der vordefinierten Latenzzeit keinen von dem Feldbusmodul 10 ermittelten Wert der ersten elektrischen Versorgungsspannung U_{P}, so kann die Steuerungseinrichtung 20 die Schalteinrichtung 40 veranlassen, auch die zweite elektrische Versorgungsspannung U_{S} sicher abzuschalten.

Die Latenzzeit kann beispielsweise anhand von Zertifizierungsrichtlinien festgelegt werden, die eine zeitliche Spezifikation festlegen, an die das System angepasst werden kann. Beispielsweise kann die Latenzzeit größer oder gleich derjenigen Zeitspanne bemessen sein, innerhalb derer der in dem Feldbusmodul 10 ermittelte Wert der ersten elektrischen Versorgungsspannung U_{P} über den Datenbus 70 an die Steuerungseinrichtung 20 übermittelt ist. Auf diese Weise ist eine flexible Einsetzbarkeit des erfindungsgemäßen Systems möglich.

Ist das Feldbussystem 100 ein Teil eines größeren Feldbussystems mit einer übergeordneten Steuereinheit zur Steuerung des Automatisierungsprozesses, so kann das an der Steuerungseinrichtung 20 beginnende Feldbussystem 100 innerhalb des gesamten Feldbussystems ein Teilsystem mit insbesondere sicherheitskritischen Ausgängen bilden. Die Steuerungseinrichtung 20, die elektrische Versorgungseinrichtung 30 und die Schalteinrichtung 40 können zusammen in einem Zwischen- oder Einspeisemodul angeordnet sein, welches zwischen die übergeordnete Steuereinheit und die Eingabe-/Ausgabemodule 50 mit den sicherheitskritischen Ausgängen 53 geschaltet ist, um die Eingabe-/Ausgabemodule 50 mit den elektrischen Versorgungsspannungen U_{P} und U_{S} zu versorgen. Alternativ kann ein solches Zwischenmodul auch lediglich die Steuerungseinrichtung 20 und die Schalteinrichtung 40, nicht aber die elektrische Versorgungseinrichtung 30 umfassen. In solch einem Fall werden die erste und zweite elektrische Versorgungsspannung U_{P} und U_{S} dem Einspeisemodul separat zugeführt, beispielswiese zusammen mit dem Datenbus 70 zu der übergeordneten Steuereinheit in einem einzigen Kabel.

Bei einer weiteren alternativen Ausführungsform des Feldbussystems 100 können Funktionen der elektrischen Versorgungseinrichtung 30 und der Schalteinrichtung 40 auch zusammen in einem Gerät realisiert sein. Beispielsweise kann die Steuerungseinrichtung 20 zur Abschaltung der ersten elektrischen Versorgungsspannung U_{P} auch den die erste elektrische Versorgungsspannung U_{P} erzeugenden Teil der elektrischen Versorgungseinrichtung 30 sicher abschalten.

Bei alternativen Ausführungsformen des Feldbussystems 100 können die Steuerungseinrichtung 20 und die Schalteinrichtung 40 auch über den Datenbus 70 funktional miteinander verbunden sein, etwa über einen sicheren Datenkanal auf dem Datenbus 70. Bei weiteren alternativen Ausführungsformen des Feldbussystems 100 kann ein Teil der Eingabe-/Ausgabemodule 50 auch nicht-sicherheitskritische Ausgänge aufweisen, die im Fehlerfalle nicht in den energielosen Zustand überführt werden müssen, also weiter betrieben werden können. In dem Feldbussystem 100 kann eine dritte elektrische Spannungsversorgung bereitgestellt werden, die die nichtsicherheitskritischen Ausgänge der Eingabe-/Ausgabemodule 50 versorgt und im Fehlerfalle auch nach Abschaltung der ersten elektrischen Versorgungsspannung U_{P} weiter Leistung führt.

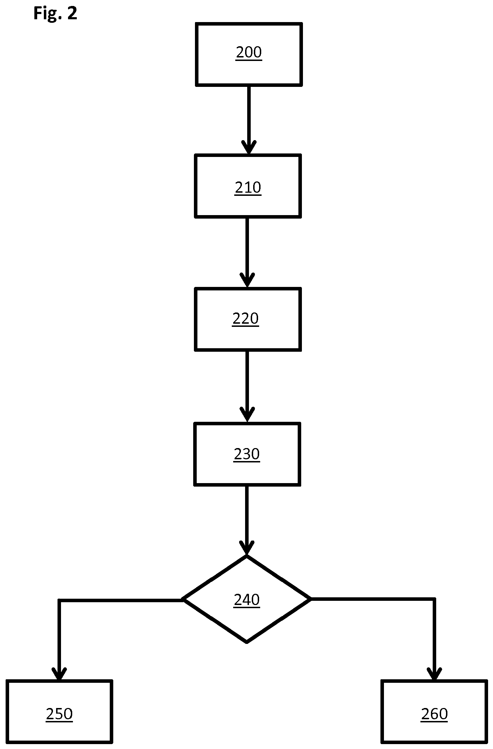

Fig. 2 zeigt ein prinzipielles Übersichtsbild eines Ablaufdiagramms einer Ausführungsform des Verfahrens zum Betreiben eines Feldbussystems 100.

In einem Schritt 200 wird ein elektrisches Versorgen wenigstens eines Eingabe-/Ausgabemoduls 50 des Feldbussystems 100 mit zwei elektrischen Versorgungsspannungen U_{P}, U_{S} durchgeführt.

In einem Schritt 210 wird ein Abschalten einer ersten elektrischen Versorgungsspannung U_{P} durchgeführt. Die erste elektrische Versorgungsspannung U_{P} kann beispielsweise der Versorgung der Aktorik des Feldbussystems 100 dienen.

In einem Schritt 220 wird ein Ermitteln eines Werts der ersten elektrischen Versorgungsspannung U_{P} mittels eines Feldbusmoduls 10 durchgeführt.

In einem Schritt 230 wird ein Übermitteln des ermittelten Werts der ersten elektrischen Versorgungsspannung U_{P} an eine Steuerungseinrichtung 20 durchgeführt.

In einem Schritt 240 wird ein Vergleichen des übermittelten Werts der ersten elektrischen Versorgungsspannung U_{P} mit einem vorbestimmten Wert der ersten elektrischen Versorgungsspannung U_{P} durchgeführt. Der vorbestimmte Wert kann beispielsweise 0V betragen.

Falls in dem Schritt 240 festgestellt wird, dass der übermittelte Wert der ersten elektrischen Versorgungsspannung U_{P} nicht mit dem vorbestimmten Wert der ersten elektrischen Versorgungsspannung U_{P} übereinstimmt, wird in einem Schritt 250 ein Abschalten einer zweiten elektrischen Versorgungsspannung U_{S} durchgeführt. Die zweite elektrische Versorgungsspannung U_{S} kann beispielsweise der Versorgung einer Sensorik des Feldbussystems 100 und/oder der Versorgung von Kommunikationseinrichtungen der Eingabe-/Ausgabemodule 50 oder des Feldbusmoduls 10 dienen.

Falls in dem Schritt 240 festgestellt wird, dass der übermittelte Wert der ersten elektrischen Versorgungsspannung U_{P} mit dem vorbestimmten Wert der ersten elektrischen Versorgungsspannung U_{P} übereinstimmt, wird in einem Schritt 260 ein Versorgen des Feldbussystems 100 mit der zweiten elektrischen Versorgungsspannung U_{S} durchgeführt.

Bei einer Weiterbildung des Verfahrens zum Betreiben eines Feldbussystems 100 kann das Verfahren nach dem Schritt 210 zum Abschalten der ersten elektrischen Versorgungsspannung U_{P} ein Überprüfen umfassen, ob eine vorbestimmte Latenzzeit abgelaufen ist oder nicht. Wurde der Schritt 230 zum Empfangen des ermittelten Werts der ersten elektrischen Versorgungsspannung U_{P} nicht bis Ablauf der Latenzzeit ausgeführt, kann als ein weiterer Schritt direkt der Schritt 250 zum Abschalten der zweiten elektrischen Versorgungsspannung U_{S} durchgeführt werden.

Zusammenfassend wird mit der Erfindung eine Art "Diagnosebox" bereitgestellt, die es in sicherheitskritischen Anwendungen der Automatisierungstechnik erlaubt, einen Status einer elektrischen Versorgungsspannung zu erkennen und an eine Steuerungseinrichtung zu übermitteln. In Reaktion auf die Meldung der Diagnosebox kann die Steuerungseinrichtung 20 die geeigneten Schritte einleiten und damit einen sicheren Betrieb der sicherheitskritischen Anwendungen ermöglichen, weil eine Rückwirkungsfreiheit zwischen den beiden elektrischen Versorgungsspannungen bereitgestellt ist.

## Patentansprüche

1. Feldbussystem (100), aufweisend:
- eine Schalteinrichtung (40) zum Schalten einer ersten elektrischen Versorgungsspannung (U_{P}) und einer zweiten elektrischen Versorgungsspannung (U_{S}),
- eine Steuerungseinrichtung (20) zum Steuern des Schaltens der elektrischen Versorgungsspannungen (U_{P}, U_{S}) durch die Schalteinrichtung (40), wobei die Steuerungseinrichtung (20) über ein Buskontaktsystem (21) an einen Datenbus (70) des Feldbussystems (100) anschaltbar ist, und
- ein Feldbusmodul (10), das mit einem Anschluss (15) zugleich an die erste elektrische Versorgungsspannung (U_{P}) und an die zweite elektrische Versorgungsspannung (U_{S}), sowie an den Datenbus (70) des Feldbussystems (100) anschaltbar ist, wobei
- mittels des Feldbusmoduls (10) ein Wert der ersten elektrischen Versorgungsspannung (U_{P}) ermittelbar und über den Datenbus (70) an die Steuerungseinrichtung (20) übermittelbar ist,
**dadurch gekennzeichnet, dass**
- mittels der Steuerungseinrichtung (20) der ermittelte Wert der ersten elektrischen Versorgungsspannung (U_{P}) mit einem vorbestimmten Wert der ersten elektrischen Versorgungsspannung (U_{P}) vergleichbar ist, wobei
- im Falle, dass der an die Steuerungseinrichtung (20) übermittelte Wert der ersten elektrischen Versorgungsspannung (U_{P}) nicht mit dem vorbestimmten Wert der ersten elektrischen Versorgungsspannung (U_{P}) übereinstimmt, mittels der Steuerungseinrichtung (20) ein Abschalten der zweiten elektrischen Versorgungsspannung (U_{S}) durch die Schalteinrichtung (40) initiierbar ist.

2. Feldbussystem (100) nach Anspruch 1 mit einem Eingabe-/Ausgabemodul (50),
wobei das Eingabe-/Ausgabemodul (50) einen Anschluss (55) zum Anschluss an die erste und zweite elektrische Spannungsversorgung (U_{P}, U_{S}) und zum Anschluss an den Datenbus (70) aufweist,
wobei das Eingabe-/Ausgabemodul (50) einen Ausgang (53) zur Ansteuerung eines Aktors aufweist,
wobei das Eingabe-/Ausgabemodul (50) dazu ausgebildet ist, eine Kommunikationseinrichtung des Eingabe-/Ausgabemoduls (50) zur Datenkommunikation über den Datenbus (70) mit Energie aus der zweiten elektrischen Spannungsversorgung (U_{S}) und den Aktor mit Energie aus der ersten elektrischen Spannungsversorgung (U_{P}) zu versorgen,
wobei das Eingabe-/Ausgabemodul (50) zwischen der Steuerungseinrichtung (20) und dem Feldbusmodul (10) angeordnet ist,
wobei die erste und zweite elektrische Spannungsversorgung (U_{P}, U_{S}) der Reihe nach von der Schalteinrichtung (40) über das Eingabe-/Ausgabemodul (50) zu dem Feldbusmodul (10) geführt sind und wobei der Datenbus (70) der Reihe nach von der Steuerungseinrichtung (20) über das Eingabe-/Ausgabemodul (50) zu dem Feldbusmodul (10) geführt ist.

3. Feldbussystem (100) nach einem der vorhergehenden Ansprüche, wobei
die erste und zweite elektrische Spannungsversorgung (U_{P}, U_{S}) zwischen der Schalteinrichtung (40) und dem Feldbusmodul (10) gemeinsam in einer elektrischen Leitung (60) geführt werden.

4. Feldbussystem (100) nach einem der vorhergehenden Ansprüche, **dadurch gekennzeichnet, dass**
die Steuerungseinrichtung (20) dazu ausgebildet ist, den Vergleich zwischen dem von dem Feldbusmodul (10) ermittelten Wert der ersten elektrischen Versorgungsspannung (U_{P}) und dem vorbestimmten Wert der ersten elektrischen Versorgungsspannung (U_{P}) nach einem Abschalten der ersten elektrischen Versorgungsspannung (U_{P}) durch die Schalteinrichtung (40) auszuführen.

5. Feldbussystem (100) nach Anspruch 4, **dadurch gekennzeichnet, dass**
die Steuerungseinrichtung (20) dazu ausgebildet ist, die zweite elektrische Versorgungsspannung (U_{S}) abzuschalten, falls nach einem Abschalten der ersten elektrischen Versorgungsspannung (U_{P}) durch die Schalteinrichtung (40) nicht innerhalb einer Latenzzeit der von dem Feldbusmodul (10) ermittelte Wert der ersten elektrischen Versorgungsspannung (U_{P}) durch die Steuerungseinrichtung (20) empfangen wird.

6. Feldbussystem (100) nach einem der vorhergehenden Ansprüche, **dadurch gekennzeichnet, dass**
das Feldbusmodul (10) und die Steuerungseinrichtung (20) dazu ausgebildet sind, den von dem Feldbusmodul (10) ermittelten Wert der ersten elektrischen Versorgungsspannung (U_{P}) über einen sicheren Datenkanal über den Datenbus (70) zu übertragen.

7. Feldbussystem (100) nach einem der vorhergehenden Ansprüche, **dadurch gekennzeichnet, dass**
das Feldbusmodul (10) als eine sichere Komponente ausgebildet ist, um den Wert der ersten elektrischen Versorgungsspannung (U_{P}) auf sichere Art und Weise zu erfassen.

8. Feldbusmodul (10) für ein eine Steuerungseinrichtung (20) umfassendes Feldbussystem (100), aufweisend:
- einen Anschluss (15), mit dem das Feldbusmodul (10) zugleich an eine erste elektrische Versorgungsspannung (U_{P}) und an eine zweite elektrische Versorgungsspannung (U_{S}), sowie an einen Datenbus (70) des Feldbussystems (100) anschaltbar ist,
- eine Spannungsmesseinrichtung (12), mittels derer ein Wert der ersten elektrischen Versorgungsspannung (U_{P}) ermittelbar ist,
**kennzeichnet durch**
- eine Kommunikationseinrichtung, mittels derer der ermittelte Wert der ersten elektrischen Versorgungsspannung (U_{P}) über den Datenbus (70) an die Steuerungseinrichtung (20) des Feldbussystems (100) übermittelbar ist, wobei
- die Spannungsmesseinrichtung (12) und die Kommunikationseinrichtung aus der zweiten elektrischen Versorgungsspannung (U_{S}) mit elektrischer Energie versorgt werden, so dass der Wert der ersten elektrischen Versorgungsspannung (U_{P}) nach einem Abschalten der zweiten elektrischen Versorgungsspannung (U_{S}) ermittelbar und an die Steuerungseinrichtung (20) übermittelbar ist.

9. Feldbusmodul (10) nach Anspruch 8,
wobei der Anschluss (15) des Feldbusmoduls (10) zur Anschaltung an eine die erste und zweite Versorgungsspannung (U_{P}, U_{S}) gemeinsam führende Leitung (60) ausgebildet ist.

10. Feldbusmodul (10) nach einem der Ansprüche 8 bis 9,
**dadurch gekennzeichnet, dass** der ermittelte Wert der ersten elektrischen Versorgungsspannung (U_{P}) über einen sicheren Datenkanal über den Datenbus (70) an die Steuerungseinrichtung (20) übermittelbar ist.

11. Feldbusmodul (10) nach einem der Ansprüche 8 bis 10,
**dadurch gekennzeichnet, dass** der Wert der ersten elektrischen Versorgungsspannung (U_{P}) auf sichere Art und Weise ermittelbar ist.

12. Verfahren zum Betreiben eines Feldbussystems (100), aufweisend die Schritte:
- elektrisches Versorgen wenigstens eines Eingabe-/Ausgabemoduls (50) des Feldbussystems (100) mit einer ersten elektrischen Versorgungsspannung (U_{P}) und einer zweiten elektrischen Versorgungsspannung (U_{S}),
- Abschalten der ersten elektrischen Versorgungsspannung (U_{P}) durch eine Steuerungseinrichtung (20) des Feldbussystems (100),
- Ermitteln eines Werts der ersten elektrischen Versorgungsspannung (U_{P}) mittels eines Feldbusmoduls (10),
**gekennzeichnet durch** die Schritte:
- Übermitteln des ermittelten Werts der ersten elektrischen Versorgungsspannung (U_{P}) von dem Feldbusmodul (10) an die Steuerungseinrichtung (20), und
- Abschalten der zweiten elektrischen Versorgungsspannung (U_{S}) **durch** die Steuerungseinrichtung (20) im Falle, dass der übermittelte Wert der ersten elektrischen Versorgungsspannung (U_{P}) nicht mit einem vorbestimmten Wert der ersten elektrischen Versorgungsspannung (U_{P}) übereinstimmt.

13. Verfahren nach Anspruch 12, wobei das Verfahren als weitere Schritte umfasst:
Versorgen eines an das Eingabe-/Ausgabemodul (50) angeschlossenen Aktors mit Energie aus der ersten elektrischen Spannungsversorgung (U_{P}) und
Versorgen einer Kommunikationseinrichtung des Eingabe-/Ausgabemoduls (50) zur Datenkommunikation über den Datenbus (70) mit Energie aus der zweiten elektrischen Spannungsversorgung (U_{S}).

14. Verfahren nach einem der Ansprüche 12 oder 13, wobei das Verfahren als weiteren Schritt umfasst:
Abschalten der zweiten elektrischen Versorgungsspannung (U_{S}) durch die Steuerungseinrichtung (20), falls der von dem Feldbusmodul (10) ermittelte Wert der ersten elektrischen Versorgungsspannung (U_{P}) nicht innerhalb einer Latenzzeit nach dem Abschalten der ersten elektrischen Versorgungsspannung (U_{P}) an die Steuerungseinrichtung (20) übermittelt wurde.

15. Verfahren nach einem der Ansprüche 13 bis 14, wobei das Ermitteln des Werts der ersten elektrischen Versorgungsspannung (U_{P}) und das Übermitteln des ermittelten Werts der ersten elektrischen Versorgungsspannung (U_{P}) an die Steuerungseinrichtung (20) von dem Feldbusmodul (10) in periodischen Abständen wiederholt werden.

## Claims

1. Fieldbus system (100) having:
- a switching device (40) for switching a first electrical supply voltage (U_{P}) and a second electrical supply voltage (U_{S}),
- a control device (20) for controlling the switching of the electrical supply voltages (U_{P}, U_{S}) by the switching device (40), wherein the control device (20) is connectable to a data bus (70) of the fieldbus system (100) via a bus contact system (21), and
- a fieldbus module (10) connectable by means of a port (15) simultaneously to the first electrical supply voltage (U_{P}) and to the second electrical supply voltage (U_{S}), and also to the data bus (70) of the fieldbus system (100), wherein
- a value of the first electrical supply voltage (U_{P}) is ascertainable and transmittable to the control device (20) via the data bus (70) by means of the fieldbus module (10),
**characterized in that**
- the ascertained value of the first electrical supply voltage (U_{P}) is comparable with a predetermined value of the first electrical supply voltage (U_{P}) by means of the control device (20), wherein
- if the value of the first electrical supply voltage (U_{P}) that is transmitted to the control device (20) is not concordant with the predetermined value of the first electrical supply voltage (U_{P}), shutdown of the second electrical supply voltage (U_{S}) by the switching device (40) is initiable by means of the control device (20).

2. Fieldbus system (100) according to Claim 1, having an input/output module (50),
wherein the input/output module (50) has a port (55) for connection to the first and second electrical voltage supplies (U_{P}, U_{S}) and for connection to the data bus (70),
wherein the input/output module (50) has an output (53) for actuating an actuator,
wherein the input/output module (50) is configured to supply a communication device of the input/output module (50) for data communication via the data bus (70) with energy from the second electrical voltage supply (U_{S}) and the actuator with energy from the first electrical voltage supply (U_{P}),
wherein the input/output module (50) is arranged between the control device (20) and the fieldbus module (10),
wherein the first and second electrical voltage supplies (U_{P}, U_{S}) are carried in turn from the switching device (40) via the input/output module (50) to the fieldbus module (10) and
wherein the data bus (70) is routed in turn from the control device (20) via the input/output module (50) to the fieldbus module (10).

3. Fieldbus system (100) according to either of the preceding claims, wherein
the first and second electrical voltage supplies (U_{P}, U_{S}) are carried between the switching device (40) and the fieldbus module (10) jointly in an electrical line (60).

4. Fieldbus system (100) according to any one of the preceding claims, **characterized in that**
the control device (20) is configured to carry out the comparison between the value of the first electrical supply voltage (U_{P}) that is ascertained by the fieldbus module (10) and the predetermined value of the first electrical supply voltage (U_{P}) after shutdown of the first electrical supply voltage (U_{P}) by the switching device (40) .

5. Fieldbus system (100) according to Claim 4, **characterized in that**
the control device (20) is configured to shut down the second electrical supply voltage (U_{S}) if the value of the first electrical supply voltage (U_{P}) that is ascertained by the fieldbus module (10) is not received by the control device (20) within a latency after shutdown of the first electrical supply voltage (U_{P}) by the switching device (40) .

6. Fieldbus system (100) according to any one of the preceding claims, **characterized in that**
the fieldbus module (10) and the control device (20) are configured to transmit the value of the first electrical supply voltage (U_{P}) that is ascertained by the fieldbus module (10) via a safe data channel via the data bus (70).

7. Fieldbus system (100) according to any one of the preceding claims, **characterized in that**
the fieldbus module (10) is configured as a safe component in order to capture the value of the first electrical supply voltage (U_{P}) in a safe manner.

8. Fieldbus module (10) for a fieldbus system (100) comprising a control device (20), having:
- a port (15) by means of which the fieldbus module (10) is connectable simultaneously to a first electrical supply voltage (U_{P}) and to to a second electrical supply voltage (U_{S}), and also to a data bus (70) of the fieldbus system (100),
- a voltage measuring device (12), by means of which a value of the first electrical supply voltage (U_{P}) is ascertainable,
**characterized by**
- a communication device, by means of which the ascertained value of the first electrical supply voltage (U_{P}) is transmittable to the control device (20) of the fieldbus system (100) via the data bus (70), wherein
- the voltage measuring device (12) and the communication device are supplied with electrical energy from the second electrical supply voltage (U_{S}), so that the value of the first electrical supply voltage (U_{P}) after the second electrical supply voltage (U_{S}) is shut down is ascertainable and transmittable to the control device (20).

9. Fieldbus module (10) according to Claim 8,
wherein the port (15) of the fieldbus module (10) is configured for connection to a line (60) carrying the first and second supply voltages (U_{P}, U_{S}) jointly.

10. Fieldbus module (10) according to either of Claims 8 and 9, **characterized in that** the ascertained value of the first electrical supply voltage (U_{P}) is transmittable to the control device (20) via a safe data channel via the data bus (70).

11. Fieldbus module (10) according to one of Claims 8 to 10, **characterized in that** the value of the first electrical supply voltage (U_{P}) is ascertainable in a safe manner.

12. Method for operating a fieldbus system (100), having the steps of:
- supplying electric power to at least one input/output module (50) of the fieldbus system (100) by means of a first electrical supply voltage (U_{P}) and a second electrical supply voltage (U_{S}),
- shutting down the first electrical supply voltage (U_{P}) by means of a control device (20) of the fieldbus system (100),
- ascertaining a value of the first electrical supply voltage (U_{P}) by means of a fieldbus module (10),
**characterized by** the steps of:
- transmitting the ascertained value of the first electrical supply voltage (U_{P}) from the fieldbus module (10) to the control device (20), and
- shutting down the second electrical supply voltage (U_{S}) by means of the control device (20) in the event of the transmitted value of the first electrical supply voltage (U_{P}) not being concordant with a predetermined value of the first electrical supply voltage (U_{P}).

13. Method according to Claim 12, wherein the method comprises the further steps of:
supplying an actuator connected to the input/output module (50) with energy from the first electrical voltage supply (U_{P}) and
supplying a communication device of the input/output module (50) for data communication via the data bus (70) with energy from the second electrical voltage supply (U_{S}).

14. Method according to either of Claims 12 and 13, wherein the method comprises the further step of:
shutting down the second electrical supply voltage (U_{S}) by means of the control device (20) if the value of the first electrical supply voltage (U_{P}) that is ascertained by the fieldbus module (10) has not been transmitted to the control device (20) within a latency after the shutdown of the first electrical supply voltage (U_{P}).

15. Method according to either of Claims 13 and 14,
wherein
the ascertaining of the value of the first electrical supply voltage (U_{P}) and the transmitting of the ascertained value of the first electrical supply voltage (U_{P}) to the control device (20) are repeated by the fieldbus module (10) at periodic intervals.

## Revendications

1. Système de bus de terrain (100), comportant :
- un dispositif de commutation (40) destiné à commuter une première tension d'alimentation électrique (U_{P}) et une deuxième tension d'alimentation électrique (U_{S}),
- un dispositif de commande (20) destiné à commander la commutation des tensions d'alimentation électrique (U_{P}, U_{S}) au moyen du dispositif de commutation (40), dans lequel le dispositif de commande (20) peut être connecté par l'intermédiaire d'un système de contact de bus (21) à un bus de données (70) du système de bus de terrain (100), et
- un module de bus de terrain (10) qui peut être connecté simultanément au moyen d'une borne (15) à la première tension d'alimentation électrique (U_{P}) et à la deuxième tension d'alimentation électrique (U_{S}) ainsi qu'au bus de données (70) du système de bus de terrain (100), dans lequel
- une valeur de la première tension d'alimentation électrique (U_{P}) peut être déterminée au moyen du module bus de terrain (10) et transmise au dispositif de commande (20) par l'intermédiaire du bus de données (70), **caractérisé en ce que**
- la valeur déterminée de la première tension d'alimentation électrique (U_{P}) peut être comparée à une valeur prédéterminée de la première tension d'alimentation électrique (U_{P}) au moyen du dispositif de commande (20), dans lequel,
- dans le cas où la valeur de la première tension d'alimentation électrique (U_{P}) transmise au dispositif de commande (20) ne coïncide pas avec la valeur prédéterminée de la première tension d'alimentation électrique (U_{P}), une déconnexion de la deuxième tension d'alimentation électrique (U_{S}) peut être déclenchée par le dispositif de commutation (40) au moyen du dispositif de commande (20).

2. Système de bus de terrain (100) selon la revendication 1, comportant un module d'entrée/sortie (50),
dans lequel le module d'entrée/sortie (50) comporte une borne (55) destinée à être connectée aux première et deuxième tensions d'alimentation électriques (U_{P}, U_{S}) et à être connectée au bus de données (70),
dans lequel le module d'entrée/sortie (50) comporte une sortie (53) destinée à commander un actionneur,
dans lequel le module d'entrée/sortie (50) est conçu pour alimenter un dispositif de communication du module d'entrée/sortie (50) en énergie provenant de la deuxième alimentation en tension électrique (U_{S}) à des fins de communication de données par l'intermédiaire du bus de données (70) et pour alimenter l'actionneur en énergie provenant de la première alimentation en tension électrique (U_{P}),
dans lequel le module d'entrée/sortie (50) est disposé entre le dispositif de commande (20) et le module de bus de terrain (10),
dans lequel les première et deuxième alimentations en tension électriques (U_{P}, U_{S}) sont séquentiellement acheminées du dispositif de commutation (40) au module de bus de terrain (10) par l'intermédiaire du module d'entrée/sortie (50) et
dans lequel le bus de données (70) est séquentiellement acheminé du dispositif de commande (20) au module de bus de terrain (10) par l'intermédiaire du module d'entrée/sortie (50).

3. Système de bus de terrain (100) selon l'une des revendications précédentes, dans lequel
les première et deuxième alimentations en tension électriques (U_{P}, U_{S}) entre le dispositif de commutation (40) et le module de bus de terrain (10) sont acheminées en commun dans une ligne électrique (60).

4. Système de bus de terrain (100) selon l'une des revendications précédentes, **caractérisé en ce que** le dispositif de commande (20) est conçu pour effectuer la comparaison entre la valeur de la première tension d'alimentation électrique (U_{P}) déterminée par le module de bus de terrain (10) et la valeur prédéterminée de la première tension d'alimentation électrique (U_{P}) après une déconnexion de la première tension d'alimentation électrique (U_{P}) par le dispositif de commutation (40).

5. Système de bus de terrain (100) selon la revendication 4, **caractérisé en ce que** le dispositif de commande (20) est conçu pour déconnecter la deuxième tension d'alimentation électrique (U_{S}) dans le cas où, après une déconnexion de la première tension d'alimentation électrique (U_{P}) par le dispositif de commutation (40), la valeur de la première tension d'alimentation électrique (U_{P}) déterminée par le module bus de terrain (10) n'est pas reçue par le dispositif de commande (20) pendant un temps de latence.

6. Système de bus de terrain (100) selon l'une des revendications précédentes, **caractérisé en ce que** le module de bus de terrain (10) et le dispositif de commande (20) sont conçus pour transmettre la valeur de la première tension d'alimentation électrique (U_{P}) déterminée par le module de bus de terrain (10) par l'intermédiaire d'un canal de données sécurisé passant sur le bus de données (70) .

7. Système de bus de terrain (100) selon l'une des revendications précédentes, **caractérisé en ce que** le module de bus de terrain (10) est réalisé sous la forme d'un composant sécurisé destiné à détecter de manière sécurisée la valeur de la première tension d'alimentation électrique (U_{P}) .

8. Module de bus de terrain (10) destiné à un système de bus de terrain (100) comprenant un dispositif de commande (20), comportant :
- une borne (15) au moyen de laquelle le module de bus de terrain (10) peut être connecté simultanément à une première tension d'alimentation électrique (U_{P}) et à une deuxième tension d'alimentation électrique (U_{S}) ainsi qu'à un bus de données (70) du système bus de terrain (100),
- un dispositif de mesure de tension (12) au moyen duquel une valeur de la première tension d'alimentation électrique (U_{P}) peut être déterminée,
**caractérisé par**
- un dispositif de communication au moyen duquel la valeur déterminée de la première tension d'alimentation électrique (U_{P}) peut être transmise par l'intermédiaire du bus de données (70) au dispositif de commande (20) du système de bus de terrain (100), dans lequel
- le dispositif de mesure de tension (12) et le dispositif de communication sont alimentés en énergie électrique provenant de la deuxième tension d'alimentation électrique (U_{S}) de manière à ce que la valeur de la première tension d'alimentation électrique (U_{P}) puisse être déterminée après une déconnexion de la deuxième tension d'alimentation électrique (U_{S}) et à ce qu'elle puisse être transmise au dispositif de commande (20) .

9. Module bus de terrain (10) selon la revendication 8,
dans lequel la borne (15) du module de bus de terrain (10) est conçue pour être connectée à une ligne (60) acheminant en commun les première et deuxième tensions d'alimentation (U_{P}, U_{S}) .

10. Module bus de terrain (10) selon l'une des revendications 8 à 9, **caractérisé en ce que** la valeur déterminée de la première tension d'alimentation électrique (U_{P}) peut être transmise au dispositif de commande (20) par l'intermédiaire d'un canal de données sécurisé passant sur le bus de données (70).

11. Module bus de terrain (10) selon l'une des revendications 8 à 10, **caractérisé en ce que** la valeur de la première tension d'alimentation électrique (U_{P}) peut être déterminée de manière sécurisée.

12. Procédé pour le fonctionnement d'un système de bus de terrain (100) comprenant les étapes suivantes :
- l'alimentation électrique d'au moins un module d'entrée/sortie (50) du système de bus de terrain (100) avec une première tension d'alimentation électrique (U_{P}) et une deuxième tension d'alimentation électrique (U_{S}),
- la déconnexion de la première tension d'alimentation électrique (U_{P}) par un dispositif de commande (20) du système de bus de terrain (100),
- la détermination d'une valeur de la première tension d'alimentation électrique (U_{P}) par un module de bus de terrain (10),
**caractérisé par** les étapes suivantes :
- la transmission de la valeur déterminée de la première tension d'alimentation électrique (U_{P}) du module de bus de terrain (10) au dispositif de commande (20), et
- la déconnexion de la deuxième tension d'alimentation électrique (U_{S}) par le dispositif de commande (20) dans le cas où la valeur transmise de la première tension d'alimentation électrique (U_{P}) ne coïncide pas avec une valeur prédéterminée de la première tension d'alimentation électrique (U_{P}) .

13. Procédé selon la revendication 12, le procédé comprenant, en tant qu'étapes supplémentaires :
l'alimentation d'un actionneur connecté au module d'entrée/sortie (50) en énergie provenant de la première alimentation en tension électrique (U_{P}) et l'alimentation d'un dispositif de communication du module d'entrée/sortie (50) en énergie provenant de la deuxième alimentation en tension électrique (U_{S}) à des fins de communication de données par l'intermédiaire du bus de données (70).

14. Procédé selon l'une des revendications 12 ou 13, dans lequel le procédé comprend en tant qu'étape supplémentaire :
la déconnexion de la deuxième tension d'alimentation électrique (U_{S}) par le dispositif de commande (20) dans le cas où la valeur de la première tension d'alimentation électrique (U_{P}) déterminée par le module de bus de terrain (10) n'a pas été transmise au dispositif de commande (20) pendant un temps de latence après la déconnexion de la première tension d'alimentation électrique (Uₚ).

15. Procédé selon l'une des revendications 13 à 14, dans lequel la détermination de la valeur de la première tension d'alimentation électrique (U_{P}) et la transmission de la valeur déterminée de la première tension d'alimentation électrique (U_{P}) au dispositif de commande (20) par le module de bus de terrain (10) sont répétées à des intervalles périodiques.
